# EUROPEAN PATENT SPECIFICATION

(11) **EP 0 652 483 B1**
(45) Date of publication and mention of the grant of the patent: **13.05.1998**
(21) Application number: 94307473.2
(22) Date of filing: 12.10.1994
(51) Int. Cl.: G03F 7/004, B41C 1/10

(54) **Lithographic printing plates**
Lithographische Druckplatten
Plaques d'impression lithographiques

(30) Priority: 04.11.1993 GB 9322705
(43) Date of publication of application: 10.05.1995
(73) Proprietor: MINNESOTA MINING AND MANUFACTURING COMPANY, St. Paul, Minnesota 55133-3427 (US)
(72) Inventor: Ellis, Richard J, Great Dunmow Essex, CM6 1XA (GB); Vogel, Dennis E, Lake Elmo Minnesota 55042 (US)
(74) Representative: Bowman, Paul Alan

(56) References cited:
- WO-A-90/12342
- WO-A-92/09934
- US-A- 4 081 572
- US-A- 4 547 444
- US-A- 5 286 604

## Description

The invention relates to lithographic printing plates which are adapted for imaging by IR lasers and which do not require wet development.

Due to the widespread use in the graphic arts industry of electronic generation, storage and output of image information, there is a growing interest in providing printing plates that are imageable by lasers, preferably IR semiconductor lasers. Currently, a laser imagesetter is typically used to output an image on a film which is then used for exposure of a plate in a contact process. It also has long been recognised that direct exposure of the plate with an imagesetter or similar device would provide considerable savings in time and money.

EP0444786, JP63-208036 and JP63-274592A disclose photopolymer resists that are sensitised to the near IR. So far, none has proved commercially viable, and all require wet development to wash off the unexposed regions. EP0514145 describes a laser addressed plate in which heat generated by the laser exposure causes particles in the plate coating to melt and coalesce and hence change their solubility characteristics. Once again, wet development is required.

A somewhat different approach is disclosed US 3,787,210, US 3,962,513, EP0001068 and JP04-140191. Heat generated by laser exposure of a donor sheet is used to physically transfer a resinous material from the donor to a receptor held in intimate contact with the donor. Provided the receptor surface has suitable hydrophilic properties, it can then be used as a printing plate. This method has the advantage of not requiring any wet processing, but in order to achieve realistic write-times, a high power YAG (or similar) laser is required, which has restricted the usefulness of the method.

Polymer coatings which undergo a change in surface properties in response to light exposure are known in the art. WO92/09934 discloses coatings that become hydrophilic as a result of irradiation, and WO92/02855 describes coatings that become tacky as a result of irradiation. In both cases, the coatings comprise an acid-sensitive polymer and a photochemical source of strong acid, and in both cases the preferred acid-sensitive polymer is derived from a cyclic acetal ester of acrylic or methacrylic acid, such as tetrahydropyranyl (meth)acrylate.

WO92/02855 discloses that the acid-sensitive polymer is blended with a low-Tg polymer to produce a coating that is initially non-tacky, but on irradiation undergoes phase separation as a result of chemical conversion of the acid-sensitive polymer, and becomes tacky. Although the possibility of laser exposure is mentioned, no details are given, and there is no disclosure of IR sensitisation, only UV/visible. However, the same materials were the subject of a paper entitled "Advances in Phototackification", presented as Paper 1912-36 at the 1993 IS&T/SPIE Conference, Symposium on Electronic Science and Technology, in which it was further disclosed that the photoacid generator could be replaced by an IR dye (specifically, a squarylium dye with thiopyrylium end groups) and exposure effected with a diode laser device. The dye in question is not known to have acid-generating properties. This technology is the subject of US 5,286,604.

WO92/09934 discloses that an acid-sensitive polymer is optionally blended with one or more additional polymers such as maleic anhydride copolymers as well as a photoacid generator. Subsequent to imagewise exposure to UV/visible radiation, the exposed areas are preferentially wettable by water, and the coatings may function as lithographic printing plates requiring no wet processing. There is no disclosure of laser address.

According to the present invention there is provided a lithographic printing plate requiring no dissolution processing which comprises a substrate bearing in one or more layers a heat-sensitive coating comprising a photothermal converter in an amount to provide an optical density of at least 0.5 at the intended exposure wavelength and a polymer having pendant hydrophobic groups which react under the action of heat or acid and heat to form hydrophilic groups whereby the coating becomes relatively more hydrophilic under the action of heat. By "photothermal converter" is meant any substance capable of absorbing incident radiation and converting same to heat. In preferred embodiments, the photothermal converter absorbs infrared radiation. However, other materials which will absorb other wavelengths, e.g., visible light, and convert the same to heat may be employed, such as the materials disclosed in JP 51-88016.

The invention further extends to a method of forming a lithographic printing surface by imagewise exposing a plate as defined above by means of a laser emitting at a wavelength within the absorption spectrum of the photothermal converter.

The heat-sensitive coating comprises a photothermal converter and a polymer having pendant hydrophobic groups which react under the action of heat and/or acid to form hydrophilic groups. Most preferably, the photothermal converter generates an acid as well as heat by absorption of radiation, and/or an additional source of acid is present in the coating.

The coating is initially hydrophobic and hence readily accepts inks commonly used in lithographic printing. On exposure to radiation, preferably infrared radiation, the coating becomes relatively more hydrophilic, so that in the presence of aqueous press fountain solutions the exposed areas are ink-repellent, i.e., the plate is positive-acting.

By "more hydrophilic" is meant an increase in the wettability of the coating by aqueous solutions of substantially neutral pH (i.e. in the pH range 4 to 10), the coating retaining its structural integrity.
Increased wettability is evidenced by a decrease in the contact angle formed between the coating and the aqueous solution.

The preferred source of radiation is a laser, especially an IR laser such as a YAG laser or a laser diode, and so the plates have the unique combination of digital addressability and no requirement for wet processing.

Preferred printing plates may be formed by imaging with an exposure of less than 5.0 J/cm², generally less than 1.0 J/cm², preferably less than 0.5 J/cm², most preferably less than 0.3 J/cm² at wavelengths in the range 480-1200 nm. This enables the exposure to be carried out by relatively low power devices (e.g., less than 1W) in realistic scan times.

The heat-sensitive coating, which may be in one or two layers, typically comprises a photothermal converter and a polymer having pendant groups capable of reacting under the action of heat and/or acid to form more polar, hydrophilic groups. Examples of groups which behave in this way include t-alkyl carboxylates, e.g., t-butyl esters, as disclosed in EP0249139, t-alkyl carbonates eg t-butyl carbonates, as disclosed in Polymer Bulletin, 17, 1-6, (1987), benzyl carboxylates eg nitrobenzyl or cyanobenzyl esters as disclosed in US4963463, and dimethylbenzyl esters as disclosed in Polym.Mater.Sci.Eng. 1989, 60, 142), and alkoxyalkyl esters, as disclosed in WO92/09934. The latter are preferred, and may be represented by the formula (I):- 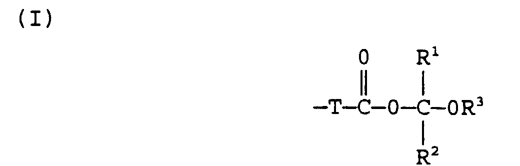 in which:
one of R¹ and R² is hydrogen and the other is hydrogen or an alkyl group of up to 18 carbon atoms,
R³ represents an alkyl group of up to 18 carbon atoms; or any two of R¹, R² and R³ may together form a ring, and
T represents a divalent linking group bonded to a polymer backbone.

Further details regarding suitable identities for T and the polymer backbone are disclosed in WO92/09934.

Preferably, R¹ is H and R² and R³ together complete a 5- or 6-membered ring.

Preferably, the polymer is derived from tetrahydropyranyl methacrylate (THPM) and has repeat units of formula (II):-

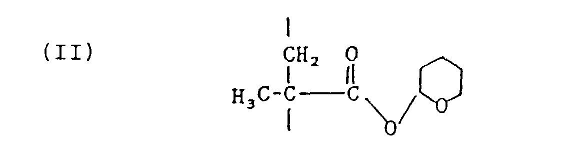

The cyclic acetal ester groups in the units of formula (II) are relatively hydrophobic and are stable at ambient temperatures under neutral or alkaline conditions. At elevated temperatures, a cleavage reaction is believed to take place, generating the corresponding carboxylic acid which is polar and hydrophilic :-

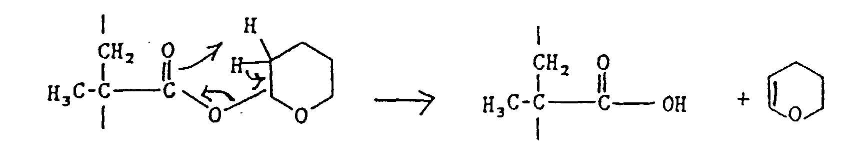

The process is greatly accelerated by the presence of acid, and enables the production of a lithographic printing surface without the need of dissolution development, since imagewise generation of heat and/or acid within a coating of the relevant polymer produces a corresponding pattern of hydrophilic (ink-repellent) and hydrophobic (ink-accepting) areas on the coating.

The properties of the reactive polymer may be enhanced by blending with other polymers, as disclosed in WO92/09934. Polymers and copolymers of maleic anhydride are particularly suitable for this purpose, and may comprise up to 90wt% of the coating, but preferably no more than 50wt%. The resulting blends show improved durability and enhanced differential in wettability.

The reactive polymer may comprise repeating units derived from one or more comonomers that do not contain heat- or acid-sensitive groups. For example, THPM (or a similar monomer) may be copolymerised with any of the conventional acrylate or methacrylate or other vinyl monomers to produce polymers with varying physical properties, provided said comonomers do not contain strongly acidic groups (such as carboxylic acid, sulphonic acid etc) which might cause unwanted cleavage of the reactive groups, or strongly basic groups (such as amino groups) which might scavenge any acid catalyst generated in the imaging process. Preferred comonomers include vinyl-functional trialkoxysilanes, such as methacryloyloxypropyltrimethoxysilane (MPTS), in quantities of up to 50 mol% of the reactive polymer. The preferred copolymer comprises 90 mol% THPM and 10 mol% MPTS.

The second essential component of plates of the invention is a photothermal converter, which is an absorber capable of absorbing the exposing radiation and converting it to heat. In order to allow address by the commonly-used lasers, such as diode lasers and YAG lasers, the absorber is generally chosen so as to provide a strong absorption in the range 650 - 1100nm, with 750-850nm preferred for laser diode address, but absorbance at other wavelengths may be used to enable exposure by other types of laser. The absorber may be present in the same layer as the reactive polymer or may be coated in a separate underlayer. The former is advantageous for ease of manufacture, but the latter has given high sensitivity. Placing the photothermal converter in an underlayer allows larger quantities to be used without risk of altering the properties of the reactive polymer. Regardless of location, the photothermal converter must be present in quantities sufficient to provide an optical density (OD) at the exposure wavelength of at least 0.5, preferably at least 0.75, more preferably at least 1.0.

In principle, any absorbing material may be used provided it absorbs sufficiently strongly in the desired wavelength range and can be incorporated or fabricated into a uniform coating. Both dyes and pigments may be used, and in the case of dual-layer constructions, vapour-deposited layers of dyes or pigments (including metals or metal oxides) are possible. Techniques for forming such layers are well known in the art, and are described for example in US 4,430,366, US 4,364,995, US 4,268,541, US 4,271,256, US 4,587,198, US 4,599,298 and US 4,657,840.

Any of the well-known IR-absorbing dyes and pigments may be used in the construction of printing plates of the invention, but a highly-preferred class are those which generate an acid on irradiation. Examples of IR-absorbing dyes having this property include aromatic diamine dicationic dyes having counterions derived from strong acids, as disclosed in WO90/12342 and US 4,656,121. The dyes commercially available from American Cyanamid under the tradenames CYASORB IR 165, 126 and 99 are of this type, and absorb in the YAG laser wavelength range. An alternative dye class, compatible with diode laser address, are the tetra-arylpolymethine (TAPM) dyes, which are disclosed, for example, in US 5,135,842. Preferred examples have a nucleus of general formula (III):- 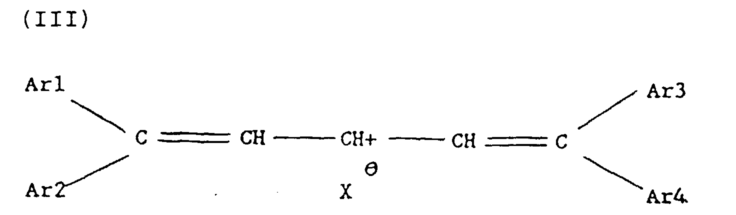 in which:
Ar¹ to Ar⁴ are aryl groups which may be the same or different such that at least two of Ar¹ to Ar⁴ have a tertiary amino group in the 4-position, and X is an anion. Examples of tertiary amino groups include dialkylamino groups, diarylamino groups, and cyclic substituents such as pyrrolidino, morpholino, piperidino etc. The tertiary amino group may form part of a fused ring system, eg one or more of Ar¹ to Ar⁴ may represent a julolidine group.

Preferably the anion X is derived from a strong acid (eg HX should have a pKa of less than 3, preferably less than 1). Suitable identities for X include ClO₄, BF₄, CF₃SO₃, PF₆, AsF₆, SbF₆, etc. Such dyes are believed to form the acid HX on irradiation, and the effect appears to be particularly strong when not all of Ar¹ to Ar⁴ are identical. Preferred dyes of formula (III) include the following :-

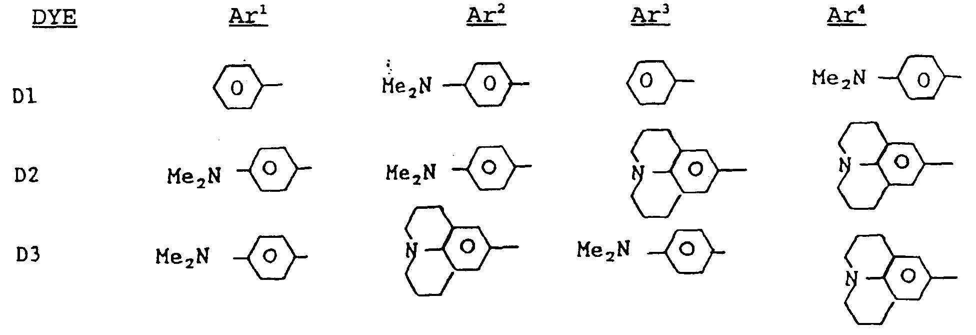

(X = CF₃S0₃ in each case)

In order to increase the sensitivity of the plate, it is beneficial to include a third ingredient, namely a thermal acid generator, in the construction. Such a compound has the property of releasing an acid under the action of heat generated by irradiation of the photothermal converter. Since the cleavage reaction of the reactive polymer is acid-catalysed, the thermal acid source serves to increase the sensitivity, and enables shorter writing times for a given laser power. Any thermal acid generator known in the art can in principle be used, but a preferred class are the trihalomethylheterocycles, particularly trichloromethyl heterocycles. Such compounds are believed to generate halogen radicals initially under the action of heat, but in the absence of scavenging species these undergo further reactions to produce the corresponding hydrohalic acid. Suitable compounds of this class include trichloromethyl triazines, e.g., tris (trichloromethyl)-s-triazine.

Another class of thermal acid generators are the "onium" salts such as diaryliodonium and triarylsulphonium salts in which the anion is derived from a strong acid. These are known to decompose under the action of heat (as well as by photolysis) to produce a strong acid, and hence find use in the present invention. Iodonium salts are preferred, and may be used in combination with a copper(II) salt and a hydroxy compound as taught by Crivello, Lockhard and Lee, J.Polymer Science, Polymer Chemistry Edition, 21, 97 (1983).

The thermal acid generator is generally used in an amount corresponding to 1.0 to 35.0 wt% of the total solids, more commonly 2.0 to 30.0 wt%, depending on the particular compound chosen. Generally speaking, trichloromethyltriazines are used at relatively high loadings (8 to 25 wt%) and iodonium salts at lower loadings (2 to 15 wt%). In two-layer constructions, the acid generator may be present in either or both of the layers.

The substrate on which the layer(s) are coated may be chosen from a wide variety of materials, the only requirement being that it be sufficiently flexible and dimensionally stable to permit mounting and running on press. There is no need for the expensive surface treatments that are given to conventional lithographic supports. Thus a variety of cheap materials such as plastics, paper and metal e.g. aluminium may be used. Preferred materials are aluminium and polyester sheet (e.g., of 4 micron thickness) optionally treated by any of the conventional methods for improving the wettability and adhesion of subsequently applied coatings (e.g., corona treatment, subbing layers, etc.).

The layer(s) of the invention may be applied by any of the conventional coating methods such as knife coating, roller coating, slot coating, curtain coating, bar coating etc. In the case of two-layer constructions, the layer comprising the absorber is applied first. This is preferably as thin as possible (e.g., < 1 micron), consistent with achieving the necessary OD and maintaining even coverage. For this reason, binder-free coatings are preferred, although this is not essential and if the absorbing dye or pigment is not inherently film-forming, it may be coated out as a solution or dispersion in a suitable binder. An alternative route to binder-free coatings is vapour deposition. This is particularly suitable for fabricating thin, highly absorbing coatings of pigments such as metals, metal oxides, phthalocyanines etc.

The layer comprising the reactive polymer is typically coated as solution of 5 to 15 wt% solids at a wet thickness of 12 microns. The layer thickness is not critical - thicker layers may give a longer press life, but at the expense of a higher energy requirement for imaging. In the case of single-layer constructions, the need to attain a given OD may dictate a minimum layer thickness.

The plates of the invention may be imaged by any of the commonly-used lasers, depending on the absorber used, but are particularly suited to address by near infrared emitting lasers such as diode lasers and YAG lasers. Any of the known scanning devices may be used, e.g., flat-bed scanners, external drum scanners or internal drum scanners. In these devices, the plate to be imaged is secured to the drum or bed (e.g., by vacuum hold-down) and the laser beam is focused to a spot (eg of about 20 microns diameter) on the surface of the plate. This spot is scanned over the entire area to be imaged while the laser is pulsed in accordance with electronically stored image information. Two or more lasers may scan different areas of the plate simultaneously, and if necessary, the output of two or more lasers may be combined optically into a single spot of higher intensity.

After imaging, the plate may be mounted on press without further treatment. Thereafter, it is preferably wiped with fountain solution prior to inking in the conventional manner. Areas of the plate that have received exposure are significantly more hydrophilic, and in the presence of damping solution are ink-repellent.

The plates are suitable for use on any conventional offset lithographic printing press, using conventional inks and fountain solutions. Plates in accordance with the invention have been shown to print several thousand impressions without sign of wear.

The invention will now be illustrated by the following Examples. Unless otherwise stated, imaging was carried out with an external drum scanner equipped with a laser diode (830 nm) delivering up to 100mW at the image plane, and focused to a 20 micron spot. The spot was scanned at linear speeds in the range 200 to 1200 cm/sec at different laser power settings. By examining the inkability or otherwise of the resulting tracks, it was possible to estimate the minimum energy per unit area required in order to effect the hydrophobic - hydrophilic transformation, and this figure is quoted as the sensitivity.

Unless otherwise stated, press testing was performed on an Apollo web-fed press using Van Son Black 40904 ink (rubber based) and newsprint paper.

All coatings were handspreads using wire-wound bars (K-Bars supplied by RK Print Coat Ltd), and were air dried at room temperature.

### Example 1

### Preparation of THPM - MPTS Copolymer

A solution of 100g tetrahydropyan-2-yl methacrylate, 10g methacryloxypropyltrimethoxysilane and 1.93g of azobisisobutyronitrile AIBN in 100cm³ of MEK was heated to 70°C for four hours. To the reaction mixture was added 583cm³ of MEK to give a solution of the copolymer at 17 weight % solids. To a 100cm³ portion of this solution was added a further 100cm³ of MEK. This mixture was then poured into 1L of methanol to precipitate the copolymer. The white solid was collected to give 23.3g of the pure copolymer.

This material, hereinafter referred to as the "Copolymer", was used in all subsequent Examples.

### Example 2

A solution of dye D1 (0.15g) in acetone (5g) was coated on polyester base at 12 micron wet thickness to provide an IR absorbing underlayer. Samples were topcoated as follows to provide Elements 1 to 3:-
Element 1 - Copolymer (0.5g) in 2-butanone (5g), 50 micron wet thickness.
Element 2 - Copolymer (0.5g) in 2-butanone (5g), 12 micron wet thickness.
Element 3 - Copolymer (0.7g) in 2-butanone (10g), 12 micron wet thickness

All three were imaged successfully at 100 dots/inch resolution, showing sensitivities of 0.1, 0.084 and 0.084 joules/cm² respectively. All three ran successfully on press using Mander Kidd fountain solution, giving at least 1000 impressions.

### Example 3

This Example shows the use of different absorbers in varying amounts in a two-layer construction.

Absorbing underlayers for Elements 4 to 8 were coated on polyester base as follows:-
Element 4 - dye D1 (0.45g), acetone (15g), 12 micron wet thickness.
Element 5 - as for 4, 36 micron wet thickness.
Element 6 - as for 4, 50 micron wet thickness.
Element 7 - dye D2 (0.044g), dichloromethane (2g), 12 micron wet thickness.
Element 8 - Dye D3 (0.044g), dichloromethane (2g), 12 micron wet thickness.

Each sample was overcoated with a 10.0wt% solution of Copolymer in 2-butanone at 12 micron wet thickness. Each was imaged and run on press successfully as described previously, except that the press tests of Elements 4 to 6 used Onyx (TM) PE366 fountain solution (from 3M) and Norset S/C paper.

The sensitivities recorded were as follows: -

| Element | 4 | 5 | 6 | 7 | 8 |
|---|---|---|---|---|---|
| OD at 830nm | 1.6 | 2.2 | 3.0 | 0.775 | 1.025 |
| Sensitivity (J/cm²) | 0.083 | 0.063 | 0.05 | 0.071 | 0.10 |

The results show that for a given absorbing dye, the sensitivity increases as the OD increases due to more efficient harnessing of the laser power. Differences in sensitivity shown by different dyes at a given OD are believed to be due to differences in their ability to generate acid.

### Example 4

This Example demonstrates single-layer constructions.

A solution of Copolymer (0.35g) and dye D1 (0.0365g) in 2-butanone (5g) was coated on polyester base at a wet thickness of 12 microns (Element 9) and 36 microns (Element 10). The dried coatings were imaged and press tested as described previously, giving the following results:-

| Element | 9 | 10 |
|---|---|---|
| OD at 830nm | 0.75 | 2.1 |
| Sensitivity (J/cm²) | 0.094 | 0.125 |

Element 9 showed the higher sensitivity, even though its absorbance was lower. It is believed the thicker layer of Element 10 required a higher input of energy to effect the hydrophobic - hydrophilic transformation.

### Example 5

This Example demonstrates the use of a vapour-deposited IR absorbing underlayer.

A 10wt% solution of Copolymer in acetone (also containing 0.02wt% dibutyltindilaurate) was coated at 12 micron wet thickness on polyester base bearing a vapour-deposited layer of vanadyl phthalocyanine (OD at 830nm 0.9). The resulting Element 11 was imaged as described previously and evaluated on a Rotaprint sheet-fed press using fountain solution of the following composition: -

| | |
|---|---|
| water | 880g |
| 2-propanol | 100g |
| orthophosphoric acid (85%) | 5.7g |
| tris(hydroxymethyl)aminomethane | 14.3g |

A sensitivity of 0.29J/cm² was recorded, which is significantly lower than for comparable plates using dyes D1 to D3. This is believed to reflect the fact that the phthalocyanine absorber does not generate acid (in contrast to dyes D1 to D3) and so imaging relies on heat generation only.

### Example 6

This Example demonstrates the use of tris(trichloro methyl)-s-triazine (TTT) as a thermal acid generator.

Elements 12 to 15 were prepared by coating polyester base with a solution of dye D1 (0.15g) in acetone (5g) at 24 micron wet thickness, followed by a topcoat (12 micron wet thickness) of a solution of Copolymer (0.35g) in 2-butanone (5g) containing varying amounts of TTT. All were imaged and evaluated on press successfully, with the following sensitivities recorded:-

| Element | 12 | 13 | 14 | 15 |
|---|---|---|---|---|
| TTT added (g) | 0 | 0.05 | 0.075 | 0.10 |
| Sensitivity (J/cm²) | 0.062 | 0.05 | 0.04 | 0.05 |

Clearly the use of TTT enhances the sensitivity.

### Example 7

This Example demonstrates the use of an iodonium salt as thermal acid generator.

Elements 16 to 19 comprised polyester base, a bottomcoat coated at 24 micron wet thickness from a solution of dye D1 (0.15g), acetone (5g) and varying amounts of iodonium salt, and a topcoat coated at 12 micron wet thickness from a solution of Copolymer (0.5g), dibutyltindilaurate (0.001g), 2-butanone (5g) and varying amounts of iodonium salt. The iodonium salt in each case was bis (4-methoxyphenyl)iodonium hexafluorophosphate. The following sensitivities were recorded after imaging and press evaluation:-

| Element | 16 | 17 | 18 | 19 |
|---|---|---|---|---|
| iodonium (bottom)* | 0 | 0 | 0.015 | 0.03 |
| iodonium (top)* | 0 | 0.05 | 0.05 | 0.05 |
| sensitivity (J/cm2) | 0.062 | 0.05 | 0.04 | 0.04 |

| | | | | |
|---|---|---|---|---|
| * - weight in grams added to coating solution. | | | | |

Addition of the iodonium salt to one or both layers clearly provides enhanced sensitivity.

### Example 8

This Example shows the use of a combination of iodonium salt and Cu(II) salt as thermal acid generator.

The following bottomcoat solutions were prepared and coated on polyester base at 24 micron wet thickness:-
Element 20 - dye D1 (0.15g), acetone (5g)
Element 21 - as for Element 20, plus iodonium salt (0.02g), copper(II) 2-ethylhexanoate (0.015g) and PKHH phenoxy resin (Union Carbide) (0.012g).

Both were overcoated with the following formulation at 24 micron wet thickness:-

Copolymer (0.5g), 2-butanone (4g), ethanol (1g), dibutytindilaurate (0.001g), iodonium salt (0.015g), copper(II) 2-ethylhexanoate(0.015g), and PKHH resin (0.025g).

After imaging and evaluation as described previously, Element 20 gave a sensitivity of 0.04 J/cm² and Element 21 0.0375 J/cm².

### Example 9

This Example demonstrates YAG laser address.

Element 22 was a two-layer construction prepared as follows:-

Bottom layer - Cyasorb IR165 (American Cyanamid) (0.15g) in 2-butanone (5g), coated at 36 micron wet thickness.

Top layer - Copolymer (0.5g), dibutyltin dilaurate (0.001g) and 2-butanone (5g), coated at 24 micron wet thickness.

Element 23 was a single-layer construction:-

Cyasorb IR165 (0.2g), Copolymer (0.5g) and acetone (4g), coated at 36 micron wet thickness.

Both were imaged by a YAG laser mounted on an internal drum scanner. The beam was focused to a 20 micron diameter spot scanned at 1600cm/sec, and the power was varied between 0.225 and 1.8 watts at the image plane. Press evaluation was carried out as described in Example 5, and the threshold sensitivity was observed to be 0.07 J/cm².

### Example 10

This Example demonstrates the use of aluminium as substrate.

The following solution was coated at 24 microns wet thickness on both polyester (Element 24) and brushed aluminium printing plate base (Element 25):-

| | |
|---|---|
| acetone | 5g |
| copolymer | 0.5g |
| dye D1 | 0.21g |
| dibutyltindilaurate | 0.001g |

Both elements were imaged by laser diode and press tested successfully as described previously, and both showed a sensitivity of 0.071 J/cm².

Element 26 was prepared by coating the above formulation at 24 micron wet thickness on anodised aluminium printing plate base, substituting Cyasorb IR165 (0.15g) for dye D1. The plate was imaged and press tested as described in Example 9 but at a scan speed of 64000cm/sec and laser power of 2 watts at the image plane, corresponding to a sensitivity of 0.1 J/cm².

## Claims

1. A lithographic printing plate requiring no dissolution processing which comprises a substrate bearing in one or more layers a heat-sensitive coating comprising a photothermal converter in an amount to provide an optical density of at least 0.5 at the intended exposure wavelength and a polymer having pendant hydrophobic groups which react under the action of heat or acid and heat to form hydrophilic groups whereby the coating becomes relatively more hydrophilic under the action of heat.

2. A lithographic printing plate as claimed in Claim 1 in which the pendant hydrophobic groups are selected from t-alkyl carboxylates, t-alkyl carbonates, benzyl carboxylates and alkoxyalkyl esters.

3. A lithographic printing plate as claimed in Claim 2 in which the pendant hydrophobic groups have the formula (I) 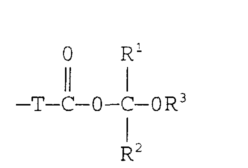 in which:
one of R¹ and R² is hydrogen and the other is hydrogen or an alkyl group of up to 18 carbon atoms,
R³ represents an alkyl group of up to 18 carbon atoms; or any two of R¹, R² and R³ may together form a ring, and
T represents a divalent linking group bonded to a polymer backbone.

4. A lithographic printing plate as claimed in Claim 3 in which the polymer comprises repeat units of the formula (II)

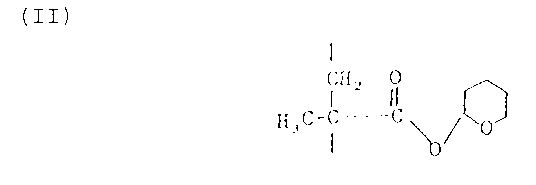

5. A lithographic printing plate as claimed in Claim 4 in which the polymer is a copolymer with an acrylate, methacrylate or other vinyl polymer.

6. A lithographic printing plate as claimed in Claim 5 in which the polymer is a copolymer of tetrahydropyranylmethacrylate (THPM) and methacryloyloxypropyltrimethoxysilane (MPTS).

7. A lithographic printing plate as claimed in Claim 6 in which the copolymer comprises no more than 50 mol % MPTS.

8. A lithographic printing plate as claimed in Claim 7 in which the copolymer comprises about 90 mol % THPM and 10 mol % MPTS.

9. A lithographic printing plate as claimed in any preceding Claim which comprises a photothermal converter in an amount to provide an optical density at the exposure wavelength of at least 0.75.

10. A lithographic printing plate as claimed in any preceding Claim which comprises a photothermal converter which generates an acid upon irradiation.

11. A lithographic printing plate as claimed in Claim 10 in which the photothermal converter comprises an aromatic diamine dicationic dye having a counterion derived from a strong acid or is a compound having a nucleus of the formula (III) 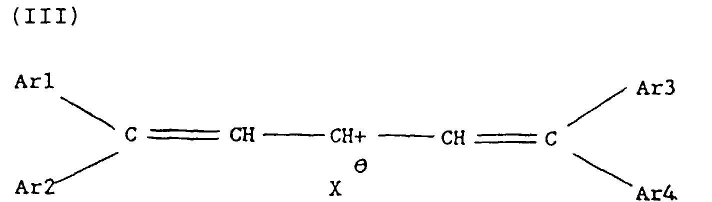 in which:
Ar¹ to Ar⁴ are aryl groups which may be the same or different such that at least two of Ar¹ to Ar⁴ have a tertiary amino group in the 4-position, and X is an anion.

12. A lithographic printing plate as claimed in any preceding Claim which additionally comprises a thermal acid generator selected from trihalomethyl-heterocyclic compounds and diaryliodonium and triarylsulphonium salts in which the anion is derived from a srong acid.

13. A lithographic printing plate as claimed in Claim 12 in which the thermal acid generator is a trichloromethyl triazine.

14. A lithographic printing plate as claimed in Claim 12 or Claim 13 in which the thermal acid generator is present in an amount of from 2 to 30% by weight of the total solids in the heat-sensitive medium.

15. A method of forming a lithographic printing surface which comprises providing a substrate bearing in one or more layers a heat-sensitive coating comprising a photothermal converter in an amount to provide an optical density of at least 0.5 at the intended exposure wavelength and a polymer having pendant hydrophobic groups which react under the action of heat or acid and heat to form hydrophilic groups whereby the coating becomes relatively more hydrophilic under the action of heat, and imagewise exposing the heat-sensitive coating by means of a laser emitting radiation at a wavelength within the absoprtion spectrum of the photothermal converter.

16. A method of forming a lithographic printing plate for printing which comprises image wise exposing a printing plate as claimed in any preceding Claim by means of a laser emitting radiation at a wavelength within the absorption spectrum of the photothermal converter.

17. A method of printing which comprises forming a printing plate as claimed in Claim 16, mounting the plate on a press, inking the plate and printing from said plate.

18. A method as claimed in Claim 17 which comprises the step of applying a fountain solution to the plate prior to inking.

## Patentansprüche

1. Lithographische Druckplatte, die keine Lösungsverarbeitung erfordert, umfassend ein Substrat, das in einer oder mehreren Schichten eine wärmeempfindliche Beschichtung trägt, umfassend einen photothermischen Konverter in einer solchen Menge, daß bei der beabsichtigten Belichtungswellenlänge eine optische Dichte von wenigstens 0,5 bereitgestellt wird, sowie ein Polymer mit hydrophoben Seitengruppen, die unter Einwirkung von Wärme oder Säure und Wärme unter Erzeugung von hydrophilen Gruppen reagieren, wobei die Beschichtung unter Einwirkung von Wärme verhältnismäßig stärker hydrophil wird.

2. Lithographische Druckplatte nach Anspruch 1, in der die hydrophoben Seitengruppen aus t-Alkylcarboxylaten, t-Alkylcarbonaten Benzylcarboxylaten und Alkoxyalkylestern ausgewählt sind.

3. Lithographische Druckplatte nach Anspruch 2, in der die hydrophoben Seitengruppen die Formel (I) aufweisen 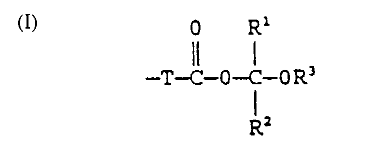 in der:
einer der Reste R¹ und R² ein Wasserstoffatom und der andere ein Wasserstoffatom oder ein Alkylrest mit bis zu 18 Kohlenstoffatomen ist,
R³ einen Alkylrest mit bis zu 18 Kohlenstoffatomen bedeutet; oder zwei beliebige Reste aus R¹, R² und R³ zusammen einen Ring ausbilden, und
T einen zweiwertigen verknüpfenden Rest bedeutet, der an ein Polymergrundgerüst gebunden ist.

4. Lithographische Druckplatte nach Anspruch 3, in der das Polymer sich wiederholende Einheiten der Formel (II) umfaßt.

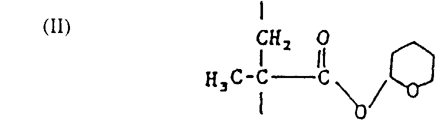

5. Lithographische Druckplatte nach Anspruch 4, in der das Polymer ein Copolymer mit einem Acrylat, Methacrylat oder einem anderen Vinylpolymer ist.

6. Lithographische Druckplatte nach Anspruch 5, in der das Polymer ein Copolymer aus Tetrahydropyranylmethacrylat (THPM) und Methacryloyloxypropyltrimethoxysilan (MPTS) ist.

7. Lithographische Druckplatte nach Anspruch 6, in der das Copolymer nicht mehr als 50 Mol-% MPTS umfaßt.

8. Lithographische Druckplatte nach Anspruch 7, in der das Copolymer etwa 90 Mol-% THPM und 10 Mol-% MPTS umfaßt.

9. Lithographische Druckplatte nach einem beliebigen der vorhergehenden Ansprüche, die einen photothermischen Konverter in einer solchen Menge umfaßt, daß bei der Belichtungswellenlänge eine optische Dichte von wenigstens 0,75 bereitgestellt wird.

10. Lithographische Druckplatte nach einem beliebigen der vorhergehenden Ansprüche, die einen photothermischen Konverter umfaßt, der beim Belichten eine Säure erzeugt.

11. Lithographische Druckplatte nach Anspruch 10, in welcher der photothermische Konverter einen dikationischen aromatischen Diamin-Farbstoff mit einem von einer starken Säure stammenden Gegenion umfaßt oder eine Verbindung ist, die einen Kern der Formel (III) aufweist 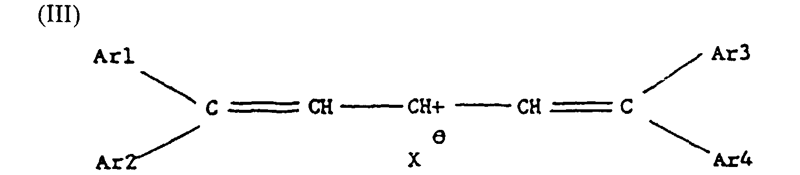 in der:
Ar¹ bis Ar⁴ Arylreste sind, die gleich oder verschieden sein können, so daß wenigstens zwei der Reste Ar¹ bis Ar⁴ einen tertiär-Aminrest in der 4-Position aufweisen, und X ein Anion ist.

12. Lithographische Druckplatte nach einem beliebigen der vorhergehenden Ansprüche, die zusätzlich ein Mittel umfaßt, das thermisch Säure erzeugt, ausgewählt aus heterocyclischen Triha 10 genmethyl-Verbindungen und Diaryliodonium- und triarylsulphoniumsalzen, in denen das Anion von einer starken Säure stammt.

13. Lithographische Druckplatte nach Anspruch 12, in welcher das Mittel, welches thermisch Säure erzeugt, ein Trichlormethyltriazin ist.

14. Lithographische Druckplatte nach Anspruch 12 oder Anspruch 13, in welcher das Mittel, welches thermisch Säure erzeugt, in einer Menge von 2 bis 30 Gewichts-% der Feststoffe insgesamt im wärmeempfindlichen Medium vorhanden ist.

15. Verfahren der Erzeugung einer lithographischen Druckoberfläche, umfassend Bereitstellen eines Substrats, welches in einer oder mehreren Schichten eine wärmeempfindliche Beschichtung trägt, umfassend einen photothermischen Konverter in einer solchen Menge, daß bei der beabsichtigten Belichtungswellenlänge eine optische Dichte von wenigstens 0,5 bereitgestellt wird, sowie ein Polymer mit hydrophoben Seitengruppen, die unter Einwirkung von Wärme oder Säure und Wärme unter Erzeugung von hydrophilen Gruppen reagieren, wobei die Beschichtung unter Einwirkung von Wärme verhältnismäßig stärker hydrophil wird, und bildweises Belichten der wärmeempfindlichen Beschichtung mittels einer laseremittierenden Strahlung bei einer Wellenlänge innerhalb des Absorptionsspektrums des photothermischen Konverters.

16. Verfahren der Erzeugung einer lithographischen Druckplatte zum Drucken, umfassend bildweises Belichten einer Druckplatte nach einem beliebigen der vorhergehenden Ansprüche, mittels einer laseremittierenden Strahlung bei einer Wellenlänge innerhalb des Absorptionsspektrums des photothermischen Konverters.

17. Druckverfahren, umfassend Erzeugen einer Druckplatte nach Anspruch 16, Einbauen der Platte in eine Presse, Einfarben der Platte und Drucken mit dieser Platte.

18. Verfahren nach Anspruch 17, umfassend die Schritte des Auftragens einer Tintenlösung auf die Platte vor dem Einfärben.

## Revendications

1. Plaque d'impression lithographique ne nécessitant pas de traitement de dissolution, qui comprend un substrat portant en une ou plusieurs couches, un revêtement thermosensible comprenant un convertisseur photothermique en une quantité suffisante pour fournir une densité optique d'au moins 0,5 à la longueur d'onde d'exposition prévue, et un polymère qui a des groupes latéraux hydrophobes qui réagissent sous l'effet de la chaleur ou d'un acide et de la chaleur, pour former des groupes hydrophiles où le revêtement devient relativement plus hydrophile sous l'effet de la chaleur.

2. Plaque d'impression lithographique selon la revendication 1, où on choisit les groupes hydrophobes latéraux parmi les carboxylates de t-alkyle, les carbonates de t-alkyle, les carboxylates de benzyle et des esters d'alcoxyalkyle.

3. Plaque d'impression lithographique selon la revendication 2, où les groupes hydrophobes latéraux ont la formule (I) 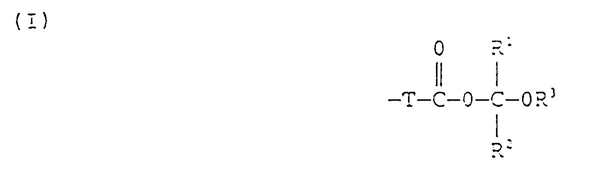 où :
l'un des groupes R¹ et R² est un hydrogène, et l'autre est un hydrogène ou un groupe alkyle ayant jusqu'à 18 atomes de carbone, R³ représente un groupe alkyle ayant jusqu'à 18 atomes de carbone ; ou deux quelconques des groupes R¹, R² et R³ peuvent former ensemble un cycle, et
T représente un groupe de liaison divalent fixé à un squelette polymère.

4. Plaque d'impression lithographique selon la revendication 3, où le polymère comprend des motifs répétés de formule (II)

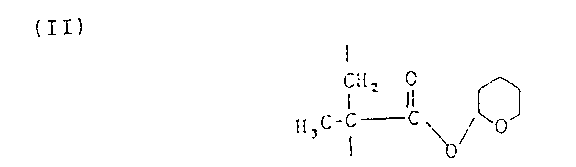

5. Plaque d'impression lithographique selon la revendication 4, où le polymère est un copolymère avec un acrylate, un méthacrylate ou un autre polymère vinylique.

6. Plaque d'impression lithographique selon la revendication 5, où le polymère est un copolymère de méthacrylate de tétrahydropyranyle (THPM) et de méthacryloyloxypropyltriméthoxysilane (MPTS).

7. Plaque d'impression lithographique selon la revendication 6, où le copolymère ne comprend pas plus de 50% molaire de MPTS.

8. Plaque d'impression lithographique selon la revendication 7, où le copolymère comprend environ 90% molaire de THPM et 10% molaire de MPTS.

9. Plaque d'impression lithographique selon l'une quelconque des revendications précédentes, qui comprend un convertisseur photothermique en une quantité suffisante pour produire une densité optique à la longueur d'onde d'exposition d'au moins 0,75.

10. Plaque d'impression lithographique selon l'une quelconque des revendications précédentes, qui comprend un convertisseur photothermique qui génère un acide par irradiation.

11. Plaque d'impression lithographique selon la revendication 10, où le convertisseur photothermique comprend un colorant dicationique diamine qui a un ion de signe opposé dérivé d'un acide fort, ou est un composé qui a un noyau de formule (III) 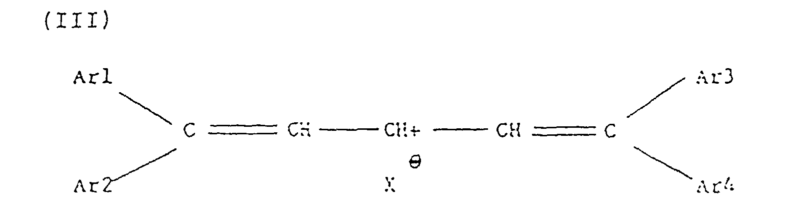 où :
Ar¹ à Ar⁴ sont des groupes aryle qui peuvent être identiques ou différents, de sorte qu'au moins deux des groupes Ar¹ à Ar⁴ ont un groupe amino tertiaire en position 4, et X est un anion.

12. Plaque d'impression lithographique selon l'une quelconque des revendications précédentes, qui comprend en plus un générateur thermique d'acide choisi parmi les composés trihalométhyle hétérocycliques et les sels de diaryliodonium et de triarylsulfonium, où l'anion est dérivé d'un acide fort.

13. Plaque d'impression lithographique selon la revendication 12, où le générateur thermique d'acide est une trichlorométhyltriazine.

14. Plaque d'impression lithographique selon la revendication 12 ou la revendication 13, où le générateur thermique d'acide est présent en une quantité de 2 à 30% en poids du total des solides dans le milieu thermosensible.

15. Procédé de formation d'une surface d'impression lithographique, qui comprend de fournir un substrat portant en une ou plusieurs couches un revêtement thermosensible comprenant un convertisseur photothermique en une quantité suffisante pour fournir une densité optique d'au moins 0,5 à la longueur d'onde prévue, et un polymère ayant des groupes hydrophobes latéraux qui réagissent sous l'effet de la chaleur ou d'un acide et de la chaleur pour former des groupes hydrophiles où le revêtement devient relativement plus hydrophile sous l'effet de la chaleur, et on expose pour former une image le revêtement thermosensible au moyen d'un laser émettant un rayonnement à une longueur d'onde dans le spectre d'absorption du convertisseur photothermique.

16. Procédé de formation d'une plaque d'impression lithographique pour l'impression, qui comprend d'exposer pour former une image une plaque d'impression selon l'une quelconque des revendications précédentes au moyen d'un laser émettant un rayonnement à une longueur d'onde dans le spectre d'absorption du convertisseur photothermique.

17. Procédé d'impression qui comprend de former une plaque d'impression selon la revendication 16, de monter la plaque sur une machine d'impression, d'encrer la plaque et d'imprimer à l'aide de ladite plaque.

18. Procédé selon la revendication 17, qui comprend l'étape d'application d'une solution de mouillage sur la plaque avant l'encrage.
